# FASCICULE DE BREVET EUROPEEN

(11) **EP 1 089 290 B1**
(45) Date de publication et mention de la délivrance du brevet: **23.12.2009**
(21) Numéro de dépôt: 00402443.6
(22) Date de dépôt: 05.09.2000
(51) Int. Cl.: G11C 16/24, G11C 7/12

(54) **Registre de colonnes, mémoire l'incorporant et procédé d'écriture dans une telle mémoire**
Speicher mit Spaltenregister und Schreibverfahren hierfür
Memory with column register and writing method

(30) Priorité: 29.09.1999 FR 9912149
(43) Date de publication de la demande: 04.04.2001
(73) Titulaire: STMicroelectronics S.A., 92120 Montrouge (FR)
(72) Inventeur: Zink, Sébastien, Cabinet Ballot-Schmit, 75116 Paris (FR); Bertrand, Bertrand, c/o Cabinet Ballot-Schmit, 75116 Paris (FR); Naura, David,c/o Cabinet Ballot-Schmit, 75116 Paris (FR)
(74) Mandataire: Viering, Jentschura & Partner

(56) Documents cités:
- US-A- 4 887 242
- US-A- 5 615 149

## Description

La présente invention concerne un registre de colonnes convenant pour une mémoire en circuit intégré, notamment en technologie EEPROM, une mémoire en circuit intégré l'incorporant, et un procédé d'écriture dans ladite mémoire.

Elle se rapporte au domaine des mémoires en circuits intégrés, notamment en technologie EEPROM (de l'anglais "Electrically Erasable and Programmable Read Only Memory" qui signifie mémoire à lecture seule programmable et effaçable électriquement "), de type série ou parallèle.

Une telle mémoire comprend des cellules organisées en matrice de lignes et de colonnes. Une cellule mémoire mémorise la valeur d'un bit de la mémoire. Les cellules d'une même colonne sont connectées à une même ligne de connexion, classiquement représentée verticalement et appelée ligne de bits. En outre, les cellules d'une même ligne sont connectées à une même ligne de connexion, classiquement représentée horizontalement et appelée ligne de mots.

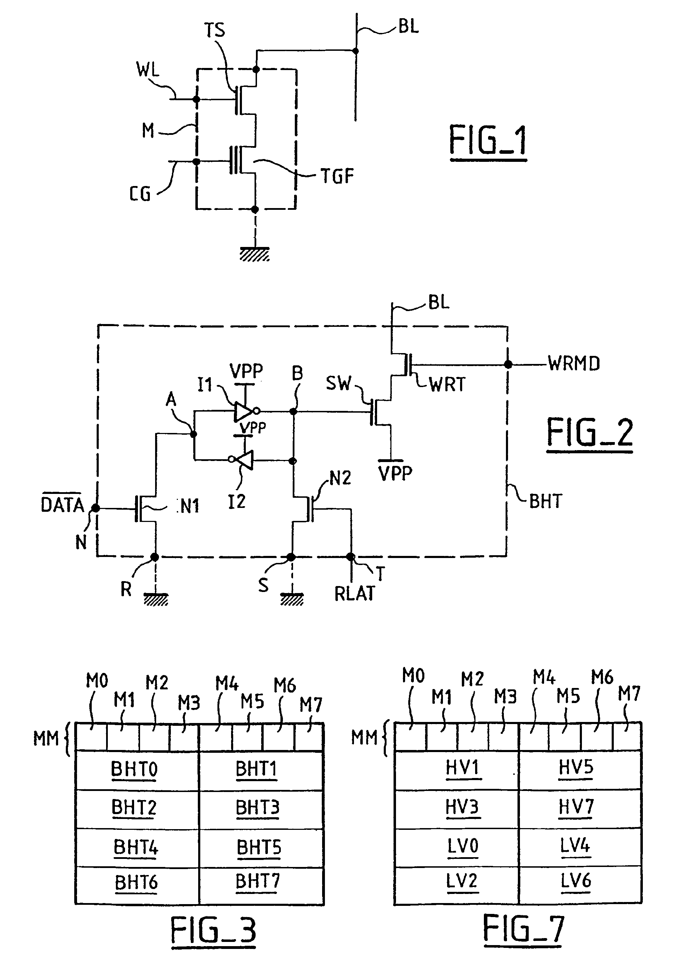

Comme représenté à la figure 1, une cellule M comprend un transistor à grille flottante TGF formant élément de mémorisation non volatile, dont le drain est connecté à la ligne de bits BL par l'intermédiaire d'un transistor de sélection TS, qui est un transistor MOS de type N. En fonctionnement, les sources des transistors à grille flottante d'une même ligne sont reliées à la masse, en général par l'intermédiaire d'un autre transistor de sélection (non représenté) commun à plusieurs cellules adjacentes. La grille de commande du transistor à grille flottante TGF est reliée à une ligne de commande de grille CG. Celle du transistor de sélection TS est reliée à la ligne de mots WL.

L'effacement et la programmation d'une cellule EEPROM s'effectuent par effet tunnel ("Fowler Nordheim"). A cet effet, une haute tension de programmation VPP, de l'ordre de 18 volts, est générée par tout dispositif adapté à partir de la tension d'alimentation VCC de la mémoire, qui est de l'ordre de 5 volts.

Une cellule effacée est une cellule dans laquelle la grille flottante du transistor TGF est chargée négativement. Pour effacer une cellule il faut donc lui appliquer des tensions permettant de "piéger" des électrons libres dans la grille flottante. Ainsi, il faut appliquer la tension VPP sur la ligne CG et sur la ligne WL, et appliquer la tension nulle sur la ligne BL ou mettre cette ligne dans l'état haute impédance. L'état effacé de la cellule correspond par exemple à la mémorisation d'une donnée binaire 1.

Une cellule programmée est une cellule dans laquelle la grille flottante du transistor TGF est chargée positivement. Pour programmer une cellule, il faut donc lui appliquer des tensions permettant "d'arracher" des électrons à la grille flottante. Ainsi, il faut appliquer la tension VPP sur la ligne BL et sur la ligne WL, et appliquer une tension nulle sur la ligne CG. L'état programmé de la cellule correspond par exemple à la mémorisation d'une donnée binaire 0.

Selon l'exemple ci-dessus, l'écriture d'une donnée binaire quelconque dans une cellule comprend une étape d'effacement de la cellule (en sorte qu'elle mémorise la donnée binaire 1), puis, lorsque la donnée binaire à écrire est 0, une étape de programmation de la cellule. L'étape d'effacement préalable à l'étape de programmation permet de maîtriser la charge de la grille flottante en toutes circonstances. L'étape de programmation est conditionnelle en ce sens qu'elle n'a lieu que si la donnée binaire à écrire est 0.

Pour la mise en oeuvre de l'étape de programmation, la mémoire comprend, pour chaque ligne de bits, une bascule haute tension de mémorisation et de commutation ou plus simplement bascule haute tension ("High Voltage Latch", en anglais). Cette bascule fait partie d'un registre appelé registre de lignes de bits ou registre de colonnes. Une telle bascule présente une double fonction. D'une part elle permet la mémorisation d'une donnée binaire en vue de l'écriture dans une cellule. D'autre part elle permet de porter à la tension VPP la ligne de bits à laquelle est reliée ladite cellule, si la donnée binaire à écrire est 0. On parle de commutation conditionnelle pour désigner cette seconde fonction de la bascule.

A la figure 2, on a représenté le schéma d'une bascule haute tension telle qu'elle est connue dans l'état de la technique.

La bascule BHT représentée à la figure 2 comprend tout d'abord des moyens de mémorisation haute tension, pour la mémorisation temporaire d'une donnée binaire 1 ou 0, sous la forme respectivement d'une haute tension VPP ou d'une tension nulle.

Ces moyens comprennent classiquement deux inverseurs I1 et I2 connectés "tête-bêche" entre un noeud A et un noeud B de manière à produire l'effet de mémorisation. Ce sont des inverseurs haute tension, c'est à dire qu'ils peuvent recevoir et délivrer une tension soit nulle soit égale à VPP. Il s'agit classiquement d'inverseurs en technologie CMOS, c'est à dire comprenant un transistor MOS de type P et un transistor MOS de type N en série entre la source de haute tension VPP et la masse, les grilles de commande des deux transistors étant reliées ensemble, et la sortie de l'inverseur étant prise sur le noeud correspondant à la source commune des deux transistors. Par convention, la sortie des moyens de mémorisation est prise sur le noeud B et leur entrée est prise sur le noeud A. Dit autrement, la donnée binaire mémorisée par la bascule est 0 lorsque le noeud B est porté à la tension nulle (potentiel de la masse) et est 1 lorsque le noeud B est porté à la haute tension VPP (potentiel référencé par rapport à la masse).

La bascule haute tension BHT comprend aussi des moyens de chargement, pour le chargement d'une donnée binaire dans les moyens de mémorisation haute tension.

Ces moyens de chargement comprennent d'une part un transistor MOS de type N, référencé N1, connecté au noeud A par son drain et à un noeud R par sa source. En fonctionnement, le noeud R est relié à la masse via un transistor de sélection (non représenté). Le transistor N1 reçoit sur sa grille de commande un signal DATA barre qui est un signal basse tension (i.e., dont le niveau est soit nul soit égal à VCC) représentant l'inverse de la donnée binaire à écrire. Dit autrement, le niveau du signal DATA barre est nul si la donnée binaire à écrire est 1 et il est égal à VCC si la donnée binaire à écrire est 0. Le signal DATA barre permet, lorsque son niveau est égal à VCC, de porter le noeud B à la tension VPP, ce qui charge la valeur binaire 1 dans les moyens de mémorisation haute tension I1,I2.

Les moyens de chargement comprennent d'autre part un autre transistor MOS de type N, référencé N2, connecté au noeud B par son drain et à un noeud S par sa source. En fonctionnement, le noeud R est relié à la masse soit directement soit via un autre transistor de sélection (non représenté). La grille de commande du transistor N2 est reliée à un noeud T pour recevoir un signal de mise à zéro RLAT, qui est aussi un signal basse tension. Ce signal permet, lorsque son niveau est égal à VCC de porter le noeud B au potentiel de masse, ce qui charge la valeur binaire 0 dans les moyens de mémorisation I1,I2.

Le chargement d'une donnée binaire dans les moyens de mémorisation I1,I2 est effectué en deux temps : dans un premier temps, le signal RLAT passe à VCC ce qui relie le noeud B à la masse à travers le transistor N2 qui est conducteur, en sorte qu'un 0 est chargé dans les moyens de mémorisation I1,I2 ; le signal RLAT repasse alors à zéro pour bloquer le transistor N2 ; dans un deuxième temps, l'inverse de la donnée binaire à écrire est porté sur la grille de commande du transistor N1 au moyen du signal DATA barre, en sorte que le noeud A est porté au potentiel de masse à travers le transistor N1 uniquement lorsque la donnée binaire à écrire est 0, ce qui a alors pour effet de charger la valeur binaire 1 dans les moyens de mémorisation I1,I2.

La bascule haute tension BHT comprend en outre des moyens de commutation conditionnelle, pour porter ou non à la tension VPP, en fonction de la valeur mémorisée par les moyens de mémorisation haute tension, la ligne de bits BL à laquelle est reliée la cellule.

Ces moyens de commutation conditionnelle comprennent un transistor MOS de type N, référencé SW, connecté à la sortie des moyens de mémorisation haute tension I1,I2 (i.e., au noeud B) par sa grille de commande, à la ligne de bit BL par sa source, et, par son drain, à la source de haute tension d'alimentation VPP à travers un transistor MOS de type N référencé WRT. Le transistor WRT reçoit sur sa grille de commande un signal WRMD qui le rend conducteur lors des opérations d'écriture dans la mémoire (i.e., en mode écriture) et qui le bloque lors des opérations de lecture dans la mémoire (i.e., en mode lecture). Le transistor WRT a donc pour fonction d'isoler la ligne de bits BL de la haute tension VPP en mode lecture. Le transistor SW assure, en mode écriture, la fonction de commutation conditionnelle de la bascule haute tension puisqu'il permet de porter la ligne de bits BL à la haute tension VPP uniquement lorsque la valeur binaire mémorisée dans les moyens de mémorisation I1,I2 est 1, c'est à dire lorsque la donnée binaire à écrire est 0.

En général, on écrit dans la mémoire au moins huit données binaires simultanément. Ces huit données binaires forment un mot de données ou mot binaire. Un mot mémoire désigne huit cellules adjacentes d'une même ligne de la mémoire mémorisant un mot binaire. Un mot mémoire mémorise donc la valeur d'un octet de la mémoire. Dans certains cas, on écrit simultanément plusieurs mots mémoire d'une même ligne de la mémoire, voire tous les mots de cette ligne : on parle alors d'écriture en mode page. Dans la suite, le terme "mot" sera parfois utilisé de manière isolée pour désigner tantôt un mot binaire tantôt un mot mémoire, selon le contexte.

L'écriture d'un mot binaire dans la mémoire comprend une étape d'effacement simultané de toutes les cellules du mot mémoire (en sorte qu'elles mémorisent la donnée binaire 1), puis une étape de programmation conditionnelle simultanément pour toutes les cellules du mot mémoire (en sorte que seules les cellules ainsi programmées mémorisent la valeur binaire 0).

Pour l'écriture d'un mot de données, huit données binaires sont chargées dans huit bascules haute tension telles que celle présentée à la figure 2. En effet, il y a en général une telle bascule par ligne de bits de la mémoire, pour permettre l'écriture simultanément dans toutes les cellules d'un même mot mémoire voire dans toutes les cellules d'une même ligne de la mémoire (en mode page).

Or les bascules haute tension telles que celle présentée à la figure 2 occupent beaucoup de place sur le substrat de silicium dopé sur lequel la mémoire est réalisée, en raison notamment de la taille des transistors qui doit leur permettre de supporter de forts courants et des tensions élevées. De ce fait, le registre de colonnes occupe une surface de silicium importante. Pour les mémoires de faible capacité (avec peu d'octets mémorisés), cette surface est comparable voire supérieure à celle occupée par le plan mémoire proprement dit. Ainsi, à la figure 3, on a représenté schématiquement la surface occupée par un plan mémoire MM de un octet comprenant huit cellules mémoire M0 à M7 formant un mot mémoire et celle occupée par les huit bascules haute tension BHT0 à BHT7 correspondantes. On conçoit que cette surface occupée par les bascules haute tension soit pénalisante en termes de coût de fabrication, surtout pour les mémoires de faible capacité.

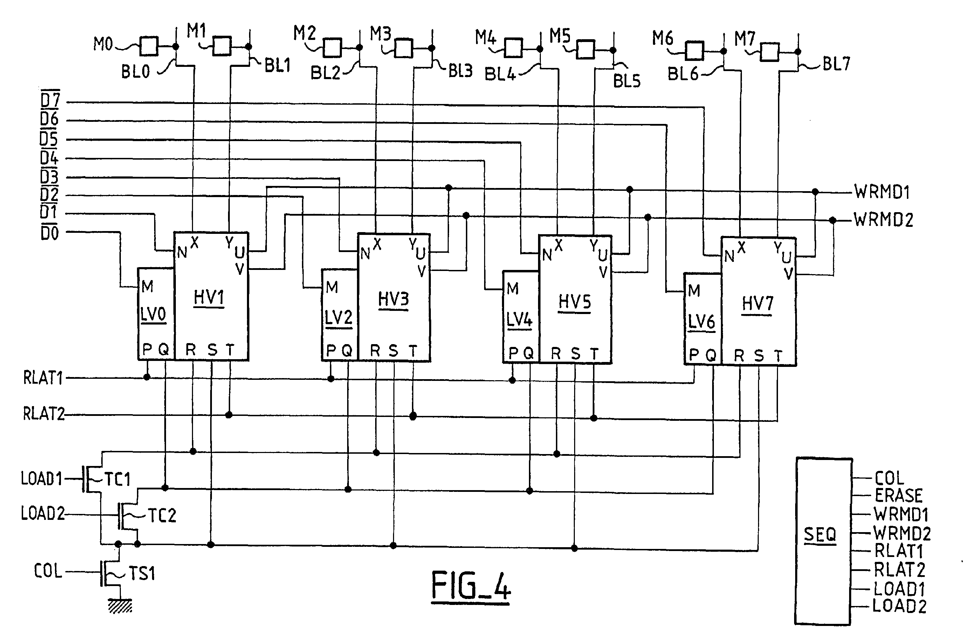

Le document US-A-4,887,242 divulgue (figs.1,2) un registre de colonnes convenant pour une mémoire en circuit intégré, notamment en technologie EEPROM, comprenant, pour un mot mémoire (2) ayant 2^{P} cellules mémoires chacune reliée à une ligne de bits respective (SC1), où p est un nombre entier non nul:
des bascules haute tension, chacune (Lt1) comprenant des moyens de mémorisation haute tension (fig.4) pour la mémorisation d'une donnée binaire sous la forme d'une haute tension de programmation (VPP') ou d'une tension nulle, couplés à des moyens (Qd11) de commutation conditionnelle et sélective, pour porter à la haute tension de programmation (VPP') une ligne de bits déterminée parmi les lignes de bits ;
des bascules basse tension, chacune (9) comprenant des moyens de mémorisation basse tension (fig.3) pour la mémorisation d'une donnée binaire sous la forme d'une basse tension d'alimentation (VCC) ou d'une tension nulle, et
des moyens (Qt1) de couplage à l'entrée d'une (Lt1) des bascules haute tension, qui peuvent être activés pour charger dans ladite bascule haute tension la donnée binaire mémorisée dans la bascule basse tension.

L'invention vise à pallier cet inconvénient des mémoires de l'état de la technique.

A cet effet, l'invention propose un registre de colonne convenant pour une mémoire en circuit intégré, notamment en technologie EEPROM, qui comprend, pour un mot mémoire ayant 2^{p} cellules mémoires chacune reliée à une ligne de bits respective :
- 2^{q} bascules haute tension, où q est un nombre entier strictement inférieur à p, chacune comprenant des moyens de mémorisation haute tension pour la mémorisation d'une donnée binaire sous la forme d'une haute tension de programmation ou d'une tension nulle, couplés à des moyens de commutation conditionnelle et sélective, pour porter à la haute tension de programmation une ligne de bits déterminée parmi 2^{p-q} lignes de bits ;
- 2^{p}-2^{q} bascules basse tension, chacune comprenant des moyens de mémorisation basse tension pour la mémorisation d'une donnée binaire sous la forme d'une basse tension d'alimentation ou d'une tension nulle, et des moyens de couplage à l'entrée d'une des bascules haute tension, qui peuvent être activés pour charger dans ladite bascule haute tension la donnée binaire mémorisée dans la bascule basse tension.

Dans un exemple qui sera détaillé plus bas, p est égal à 3 et q est égal à 2. Donc pour un mot mémoire de huit cellules mémoire, le registre de colonnes selon l'invention comporte quatre bascules haute tension et quatre bascules basse tension, au lieu des huit bascules haute tension d'un registre conforme à l'art antérieur. Or une bascule basse tension occupe beaucoup moins de place sur le substrat de silicium dopé qu'une bascule haute tension. L'invention permet donc de diminuer la place occupée globalement par le registre de colonnes sur le substrat de silicium.

L'invention concerne aussi une mémoire, notamment en technologie EEPROM, comprenant un plan mémoire avec au moins un mot mémoire de 2^{p} cellules, chacune connectée à une ligne de bits respective, qui comprend un registre de colonne tel que ci-dessus.

En outre, l'invention propose, aussi un procédé d'écriture d'au moins un mot de données de 2^{p} bits dans une telle mémoire, qui comprend les étapes suivantes :
1) effacement de toutes les cellules du mot mémoire ;
2) chargement de 2^{q} données dans les 2^{q} bascules haute tension, et chargement de 2^{p}-2^{q} autres données dans les 2^{p}-2^{q} bascules basse tension ;
3) programmation de 2^{q} cellules de la mémoire en fonction des données mémorisées dans les 2^{q} bascules haute tension,
ainsi que, répétées 2^{p-q}-1 fois, les étapes suivantes :
4) chargement, dans les 2^{q} bascules haute tension, de 2^{q} des autres données qui ont été chargées dans 2^{q} bascules basse tension à l'étape 2) ;
5) programmation de 2^{q} autres cellules de la mémoire en fonction des données mémorisées dans les 2^{q} bascules haute tension.

D'autres caractéristiques et avantages de l'invention apparaîtront à la lecture de la description qui va suivre. Celle-ci est purement illustrative et doit être lue en regard des dessins annexés, sur lesquels on a représenté :
- à la figure 1, déjà analysée : le schéma d'une cellule mémoire en technologie EEPROM ;
- à la figure 2, également déjà analysée : le schéma d'une bascule haute tension d'un registre de colonnes connu dans l'état de la technique ;
- à la figure 3, également déjà analysée : le schéma de la surface occupée par un mot mémoire d'un octet et par un registre de colonnes correspondant selon l'état de la technique ;
- à la figure 4 : le schéma d'un registre de colonnes selon l'invention ;
- à la figure 5 : le schéma détaillé d'une bascule haute tension et d'une bascule basse tension conformes à l'invention ;
- aux figures 6a à 6h : des chronogrammes de signaux intervenant dans le mode écriture de la mémoire ;
- à la figure 7 : le schéma de la surface occupée par un mot mémoire d'un octet et par un registre de colonnes correspondant selon l'invention.

A la figure 4, on a représenté le schéma d'un registre de colonnes selon l'invention.

Pour un mot mémoire comprenant huit cellules mémoire M0 à M7 chacune reliée à une lignes de bits différentes, respectivement BL0 à BL7, le registre comprend, dans un exemple simple, quatre bascules haute tension HV1, HV3, HV5 et HV7 et quatre bascules basse tension LV0, LV2, LV4, et LV6. Les bascules haute tension sont légèrement différentes à la fois fonctionnellement et structurellement, de la bascule haute tension conforme à l'art antérieur qui a été présentée à la figure 2.

Des signaux D0 barre, D2 barre, D4 barre et D6 barre correspondant à l'inverse de données à écrire sont fournis sur une entrée M des bascules basse tension respectivement LV0, LV2, LV4, et LV6. Des signaux D1 barre, D3 barre, D5 barre et D7 barre correspondant à l'inverse de données à écrire sont fournis sur une entrée N des bascules haute tension respectivement HV1, HV3, HV5 et HV7.

Les bascules haute tension HV1, HV3, HV5 et HV7 comportent deux sorties X et Y connectées à deux lignes de bits respectives de la mémoire, de préférence deux lignes de bits adjacentes pour limiter la longueur des liaisons. Il s'agit respectivement des lignes de bits BL0 et BL1 pour la bascule HV1, BL2 et BL3 pour la bascule HV3, BL4 et BL5 pour la bascule HV5 et enfin BL6 et BL7 pour la bascule HV7.

Les bascules haute tension HV1, HV3, HV5 et HV7 comportent deux entrées U et V recevant respectivement un premier signal de sélection WRMD1 et un second signal de sélection WRMD2. Il s'agit de signaux haute tension dont un seul à la fois peut avoir un niveau égal à VPP. Comme on le verra plus en détails plus loin, ces signaux permettent de sélectionner celle des deux lignes de bits connectées sur les entrées X et Y de chaque bascule haute tension qui est portée, le cas échéant (en fonction de la donnée mémorisée dans la bascule haute tension), à la haute tension de programmation VPP.

Enfin, les bascules basse tension LV0, LV2, LV4, et LV6 comportent chacune des entrées P et Q, et les bascules haute tension HV1, HV3, HV5 et HV7 comportent chacune des entrées R, S et T, pour lesquelles on notera ce qui suit :
- les entrées P des bascules basse tension reçoivent ensemble un premier signal de mise à zéro RLAT1 ;
- les entrées T des bascules haute tension reçoivent ensemble un second signal de mise à zéro RLAT2 ;
- les entrées R des bascules haute tension sont ensemble reliées ou non à la masse à travers un premier transistor de chargement TC1 et un transistor de sélection TS1, lorsque le niveau d'un premier signal de chargement LOAD1 et le niveau d'un signal COL de sélection de mot mémoire sont égaux à VCC ;
- les entrées Q des bascules basse tension sont ensemble reliées ou non à la masse à travers un second transistor de chargement TC2 et le transistor de sélection TS1, lorsque le niveau d'un second signal de chargement LOAD2 et le niveau du signal COL de sélection de mot mémoire sont égaux à VCC ;
- les entrées S des bascules haute tension sont ensemble reliées ou non à la masse à travers le transistor de sélection TS1, lorsque le niveau du signal COL de sélection de mot est égal à VCC.

A la figure 4, on a également représenté un séquenceur SEQ de la mémoire, qui génère un signal ERASE sur lequel on reviendra plus loin, ainsi que les signaux COL, WRMD1, WRMD2, RLAT1, RLAT2, LOAD1 et LOAD2 précités.

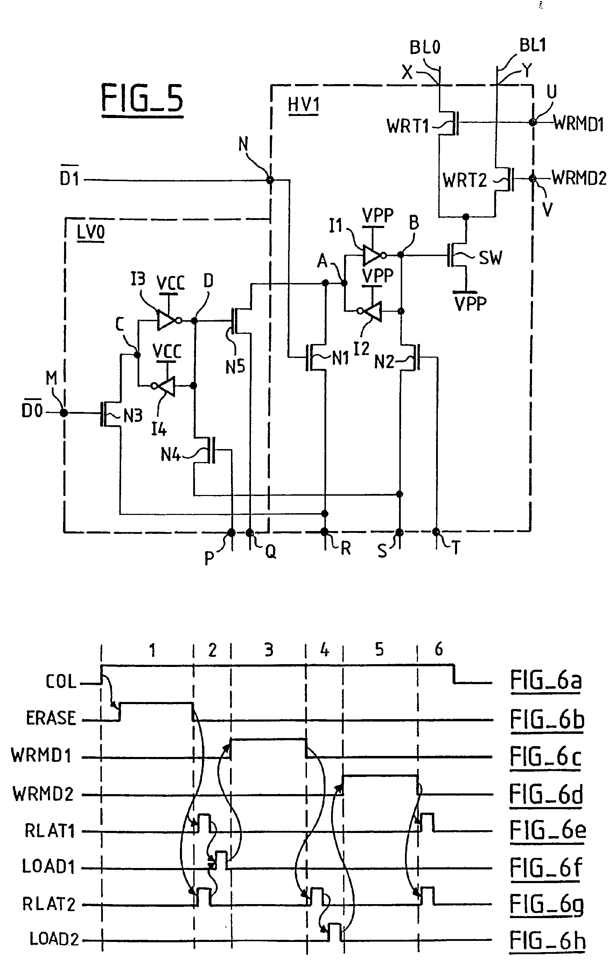

Avant de décrire le fonctionnement du registre de colonnes conforme à l'invention, on va maintenant décrire, à la fois d'un point de vue structurel et d'un point de vue fonctionnel, les bascules haute tension et les bascules basse tension conformes à l'invention. A cet effet, on se réfère à la figure 5 sur laquelle on a représenté le schéma détaillé de la bascule haute tension HV1 et de la bascule basse tension LV0. Néanmoins, il est bien entendu que la description qui va en être faite s'applique également aux autres bascules haute tension et aux autres bascules basse tension respectivement. A la figure 5, les éléments de la bascule haute tension HV1 selon l'invention qui sont identiques aux éléments de la bascule BHT selon l'art antérieur présentée à la figure 2 portent les mêmes références.

Ainsi, la bascule haute tension HV1 comprend des moyens de mémorisation haute tension, pour la mémorisation d'une donnée binaire sous la forme d'une haute tension de programmation VPP ou d'une tension nulle. Ces moyens de mémorisation haute tension comprennent deux inverseurs haute tension I1 et I2 en technologie CMOS connectés "tête-bêche" entre un noeud A et un noeud B.

Les moyens de mémorisation haute tension sont couplés selon l'invention, non pas à de simples moyens de commutation conditionnelle tels que le transistor SW de la figure 2, mais à des moyens de commutation conditionnelle et sélective. Par cette expression, on entend que de tels moyens permettent de porter à la haute tension de programmation VPP, de manière toujours conditionnelle, une ligne de bits déterminée parmi les deux lignes de bits BL0 et BL1. Ces moyens de commutation conditionnelle et sélective comprennent le transistor SW connecté par sa grille de commande à la sortie B des moyens de mémorisation haute tension I1,I2, à la haute tension de programmation VPP par son drain, et aux deux lignes de bits BL0,BL1 par l'intermédiaire d'un transistor MOS de type N respectif, référencé WRT1 et WRT2 respectivement. Les transistors WRT1 et WRT2 forment des moyens de sélection de ligne de bits.

Les grilles de commande des deux transistors WRT1 et WRT2 sont connectées respectivement aux entrées U et V de la bascule haute tension, pour recevoir les signaux de sélection WRMD1 et WRMD2 respectivement. De cette manière, les transistors WRT1 et WRT2 assurent à la fois une fonction d'isolation des lignes de bits en mode lecture (lorsque le niveau des deux signaux WRDM1 et WRMD 2 est égal à zéro), et une fonction de sélection d'une parmi les deux lignes de bits BL0 et BL1 en mode écriture (lorsque le niveau de l'un seulement des signaux WRMD1 et WRMD2 est égal à VCC). On insistera pour noter que les transistors WRT1 et WRT2 non seulement continuent d'exercer la fonction d'isolation qui leur était attribuée dans les bascules hautes tension de l'art antérieur, mais que, en outre, conformément à l'invention, ils assurent également une fonction de sélection qui s'ajoute à leur fonction d'isolation connue. Dit autrement encore, les transistors WRT1 et WRT 2 coopèrent avec le transistor SW pour assurer la fonction de commutation conditionnelle et sélective.

En outre, la bascule haute tension HV1 comprend des premiers moyens de chargement, pour le chargement d'une donnée binaire dans les moyens de mémorisation haute tension I1,I2. Ces moyens de chargement comprennent les transistors N1 et N2 déjà décrits en regard de la figure 2, ainsi que le transistor de chargement TC1 présenté plus haut en regard de la figure 4. Le fonctionnement de ces moyens découle de ce qui a été dit plus haut dans les passages précités et n'appelle pas de commentaire particulier à l'attention de l'homme du métier.

Chaque bascule basse tension telle que la bascule LV0 comprend des moyens de mémorisation basse tension pour la mémorisation d'une donnée binaire sous la forme de la basse tension d'alimentation VCC ou d'une tension nulle. Ces moyens de mémorisation basse tension comprennent deux inverseurs basse tension I3 et I4 en technologie CMOS connectés "tête-bêche" entre un noeud C et un noeud D. Un inverseur basse tension est un inverseur qui peut recevoir et délivrer un signal dont le niveau est soit nul soit égal à la basse tension d'alimentation VCC. Par convention, la sortie des moyens de mémorisation basse tension I3,I4 est prise sur le noeud D, et leur entrée sur le noeud C.

La bascule basse tension LV0 comprend des seconds moyens de chargement pour le chargement d'une donnée binaire dans les moyens de mémorisation basse tension I3,I4. Ces moyens de chargement comprennent d'une part un transistor MOS de type N référencé N3 connecté par son drain au noeud C, par sa grille de commande à l'entrée M de la bascule LV0 pour recevoir le signal D0 barre, et par sa source au drain du premier transistor de chargement TC1 (confondu ici avec l'entrée R de la bascule haute tension HV1). Ils comprennent d'autre part un transistor MOS de type N, référencé N4, connecté par son drain au noeud D, par sa grille de commande à l'entrée P de la bascule pour recevoir le signal de mise à zéro RLAT1, et par sa source au drain du transistor de sélection de mot mémoire (confondu ici avec l'entré S de la bascule haute tension HV1). Le fonctionnement des transistors N3 et N4 des seconds moyens de chargement est identique à celui, respectivement, des transistors N1 et N2 des premiers moyens de chargement décrits plus haut en regard de la figure 2. Il n'appelle donc pas de commentaire particulier à l'attention de l'homme du métier.

On notera que les premiers et les seconds moyens de chargement partagent au moins le premier transistor de chargement TC1, en sorte que les premiers et les seconds moyens de chargement peuvent être activés simultanément au moyen du premier signal de chargement LOAD1 qui est appliqué sur la grille de commande du premier transistor de chargement TC1. Cette activation simultanée a pour effet de charger une première et une seconde donnée binaires respectivement dans les moyens de mémorisation basse tension I3,I4 de la bascule basse tension et dans les moyens de mémorisation haute tension I1,I2 de la bascule haute tension, en fonction respectivement des signaux D0 barre et D1 barre. Par contre, les premiers et les seconds moyens de chargement répondent à des signaux de mise à zéro respectifs RLAT2 et RLAT1, comme il apparaîtra plus clairement dans la suite.

La bascule basse tension LV0 comprend également des moyens de couplage à l'entrée A d'une des bascules haute tension, en l'occurrence la bascule haute tension HV1. Ces moyens de couplage peuvent être activés pour charger dans la bascule haute tension HV1 la donnée binaire mémorisée dans la bascule basse tension LV0. Dit autrement, la donnée binaire mémorisée par les moyens de mémorisation basse tension I3,I4 de la bascule basse tension LV0 peut être transférée dans les moyens de mémorisation haute tension de la bascule haute tension HV1.

Les moyens de couplage de la bascule basse tension LV0 comprennent un transistor MOS de type N, référencé N5, connecté par sa grille de commande à la sortie D des moyens de mémorisation basse tension I3,I4, par son drain à l'entrée A des moyens de mémorisation haute tension I1,I2 d'une des bascules haute tension, en l'occurrence la bascule haute tension HV1, et par sa source à l'entrée Q de la bascule basse tension. De cette manière, les moyens de couplage sont activés par la sortie des moyens de mémorisation basse tension I3,I4 lorsque l'entrée Q est portée à la masse de la manière qui a été indiquée plus haut en regard de la figure 4.

On va maintenant décrire le fonctionnement du registre de colonnes de la figure 4 en se référant aux chronogrammes des figures 6a à 6h. Sur ces figures, on a représenté l'allure, pour une opération d'écriture dans la mémoire, des signaux respectivement COL, ERASE, WRMD1, WRMD2, RLAT1, LOAD1, RLAT2 et LOAD2. Les implications logiques entre les différentes transitions de ces signaux sont matérialisées par des flèches. Les signaux COL, ERASE, RLAT1, LOAD1, RLAT2 et LOAD2sont des signaux basse tension, c'est à dire que leur niveau est soit nul soit égal à VCC. Les signaux WRMD1 et WRMD2 sont des signaux haute tension, c'est à dire que leur niveau est soit nul soit égal à VPP.

Un procédé d'écriture d'un mot de donnée de huit bits dans la mémoire selon l'invention comprend les étapes qui vont maintenant être décrites.

Le procédé comprend tout d'abord une étape 1 d'effacement de toutes les cellules du mot mémoire dans lequel le mot binaire doit être écrit. Cette étape démarre par le passage à VCC du signal COL, qui a pour effet de rendre le transistor de sélection TS1 conducteur. Le mot mémoire formé des cellules mémoire M0 à M7 est alors sélectionné pour l'écriture. Le signal ERASE passe alors à VCC pour commander les circuits d'effacement de la mémoire (non représentés), qui permettent d'appliquer sur les bornes des cellules mémoires M0 à M7 les tensions nécessaires à l'effacement. Cette étape 1 se termine par le retour à zéro du signal ERASE. On notera que cette étape 1 d'effacement n'est pas forcément nécessaire si la mémoire n'est pas une mémoire en technologie EEPROM.

Le procédé comprend ensuite une étape 2 de chargement de quatre données dans les quatre bascules haute tension HV1, HV3, HV5, et HV7, et de chargement de quatre autres données dans les quatre bascules basse tension LV0, LV2, LV4 et LV6. Les données ainsi chargées sont les données inverses des données à écrire dans le mot mémoire M0-M7, et sont délivrées par les signaux D0 barre à D7 barre (figure 4).

L'étape 2 se décompose en deux temps : dans un premier temps, les signaux RLAT1 et RLAT2 passent à VCC ce qui rend conducteurs le transistor N4 des bascules basse tension LV0, LV2, LV4 et LV6 et le transistor N2 des bascules haute tension HV1, HV3, HV5, et HV7, en sorte que la donnée 0 est mémorisée par leurs moyens de mémorisation respectifs. Dans un deuxième temps, les signaux RLAT1 et RLAT2 repassent à zéro, ce qui bloque les transistors N4 et N2 précités. Le premier signal de chargement LOAD1 passe alors à VCC, ce qui rend conducteur le transistor de chargement TC1, en sorte que les données inverses des données à écrire, lorsqu'elles sont des valeurs binaires 1 délivrées par les signaux D0 barre à D7 barre (le cas échéant sous la forme de signaux de niveau égal à VCC), sont mémorisées dans les moyens de mémorisation respectifs des bascules haute tension HV1, HV3, HV5, et HV7 et des bascules basse tension LV0, LV2, LV4 et LV6. A l'issue de cette étape, les données inverses des données à écrire, quelles soient égales à 0 ou à 1, sont mémorisées dans les moyens de mémorisation respectifs I1,I2 et I3,I4 des bascules haute tension et des bascules basse tension. L'étape 2 de chargement se termine par le retour à zéro du premier signal de chargement LOAD1.

On notera que l'ordre des étapes 1 d'effacement et 2 de chargement peut être inversé.

Le procédé comprend ensuite une étape 3 de programmation de quatre cellules de la mémoire en fonction des données mémorisées dans les quatre bascules haute tension HV1, HV3, HV5, et HV7. En l'occurrence, les quatre cellules concernées sont les cellules M0, M2, M4 et M6. A cet effet, le signal WRMD1 passe à VPP (alors que le signal WRMD2 reste à zéro) en sorte que les lignes de bits BL0, BL2, BL4 et BL6 sont sélectionnées pour l'écriture. La programmation conditionnelle des cellules M0, M2, M4 et M6 a alors lieu par commutation conditionnelle de ces lignes de bits à la haute tension de programmation VPP au moyen des transistors SW, en fonction des données mémorisées dans les moyens de mémorisation haute tension des cellules haute tension HV1, HV3, HV5, et HV7. L'étape de programmation 3 se termine par le retour à zéro du signal WRMD1, qui a pour effet d'isoler à nouveau les lignes de bits BL0, BL2, BL4 et BL6 de la haute tension VPP.

Le procédé comprend ensuite une étape 4 de chargement, dans les quatre bascules haute tension HV1, HV3, HV5, et HV7, des quatre données qui ont été préalablement chargées dans les quatre bascules basse tension LV0, LV2, LV4 et LV6 à l'étape 2.

Cette étape 4 se décompose en deux temps : dans un premier temps, le signal RLAT2 passe à VCC ce qui rend conducteur le transistor N2 des bascules haute tension HV0, HV2, HV4 et HV6, en sorte que la donnée 0 est mémorisée dans leurs moyens de mémorisation respectifs. Dans un deuxième temps, le signal RLAT2 repasse à zéro ce qui bloque les transistors N2. Le second signal de chargement LOAD2 passe alors à VCC, ce qui rend conducteur le transistor de chargement TC2, en sorte que les données mémorisées dans les moyens de mémorisation basse tension I3,I4 des bascules basse tension LV0, LV2, LV4 et LV6, lorsqu'elles sont égales à 1, sont respectivement chargées dans les moyens de mémorisation haute tension I1,I2 des bascules haute tension respectivement HV1, HV3, HV5, et HV7. Pour résumer, à l'issue de cette étape, les données binaires antérieurement mémorisées dans les moyens de mémorisation basse tension I3,I4 des bascules basse tension, qu'elles soient égales à 0 ou à 1, sont mémorisées dans les moyens de mémorisation haute tension I1,I2 des bascules haute tension. Dit autrement, ces données ont été transférées à l'étape 4 depuis les moyens de mémorisation basse tension I3,I4 des bascules basse tension LV0, LV2, LV4 et LV6 vers les moyens de mémorisation haute tension I1,I2 des bascules haute tension HV1, HV3, HV5, et HV7. L'étape 4 s'achève par le retour à zéro du second signal de chargement LOAD2.

Le procédé comprend enfin une étape 5 de programmation de quatre autres cellules de la mémoire en fonction des données mémorisées dans les quatre bascules haute tension HV1, HV3, HV5, et HV7. En l'occurrence, les quatre cellules concernées sont les cellules M1, M3, M5 et M7. A cet effet, le signal WRMD2 passe à VCC (alors que le signal WRMD1 reste à zéro) en sorte que les lignes de bits BL1, BL3, BL5 et BL7 sont sélectionnées pour l'écriture. La programmation conditionnelle des cellules M1, M3, M5 et M7 a alors lieu par commutation conditionnelle de ces lignes de bits à la haute tension de programmation VPP au moyen des transistors SW, en fonction des données mémorisées dans les moyens de mémorisation haute tension I1,I2 des cellules haute tension HV1, HV3, HV5, et HV7. L'étape de programmation 5 se termine par le retour à zéro du signal WRMD2, qui a pour effet d'isoler à nouveau les lignes de bits BL1, BL3, BL5 et BL7 de la haute tension VPP.

L'étape de programmation 5 peut éventuellement mais non nécessairement être suivie d'une étape 6 de remise à zéro des moyens de mémorisation respectifs I3,I4 et I1,I2 des bascules basse tension LV0, LV2, LV4 et LV6 et des bascules haute tension HV1, HV3, HV5, et HV7. A cet effet, les signaux RLAT1 et RLAT2 passent à VCC ce qui rend conducteurs les transistors N4 des bascules basse tension LV0, LV2, LV4 et LV6 et les transistors N2 des bascules haute tension HV1, HV3, HV5, et HV7 en sorte que la donnée binaire 0 est mémorisée dans leurs moyens de mémorisation respectifs I3,I4 et I1,I2.

Le procédé d'écriture d'un mot de données dans le mot mémoire M0-M7 s'achève par le retour à zéro du signal COL de sélection de mot mémoire.

A la figure 7, on a représenté schématiquement la surface occupée par un plan mémoire MM de un octet comprenant les huit cellules mémoire M0 à M7 formant un mot mémoire et celle occupée par les quatre bascules haute tension HV1, HV3, HV5, et HV7 ainsi que par les quatre bascules basse tension LV0, LV2, LV4 et LV6. En comparant cette figure à la figure 3, on remarque que la surface occupée par un registre de colonnes selon l'invention est inférieure à celle occupée par un registre de colonne selon l'art antérieur. Ceci provient du fait que la surface occupée par une bascule basse tension est inférieure à celle occupée par une bascule haute tension.

L'invention n'a été décrite ci-dessus que dans le cas d'une exemple non limitatif dans lequel un registre de colonnes comprend, pour un mot mémoire de huit cellules mémoire, quatre bascules haute tension et quatre bascules basse tension. Néanmoins, elle peut être généralisée au cas d'un registre de colonnes comprenant, pour un mot mémoire ayant 2^{p} cellules mémoires chacune reliée à une ligne de bits respective, où p est un nombre entier non nul, 2^{q} bascules haute tension, où q est un nombre entier strictement inférieur à p, et 2^{p}-2^{q} bascules basse tension. On notera que plus q est faible, et plus le gain de surface de silicium par rapport à la surface occupée par un registre selon l'art antérieur est élevé.

Dans ce cas, les moyens de sélection des bascules haute tension permettent de sélectionner une ligne de bits déterminée parmi 2^{p-q} lignes de bits. A cet effet, il faut prévoir pour chacune 2^{p-q} transistors tels que les transistors de sélection WRT1 et WRT2 et autant de signaux de sélection tels que les signaux WRMD1 et WRMD2. En outre, plusieurs bascules basse tension sont reliées par le drain de leur transistor N5 de couplage à l'entrée A d'une même bascule haute tension. Il faut alors prévoir 2^{p-q}-1 transistors de chargement tels que le transistor TC1.

De plus, l'étape 2 de chargement concerne alors le chargement de 2^{q} données dans les 2^{q} bascules haute tension, et le chargement de 2^{p}-2^{q} autres données dans les 2^{p}-2^{q} bascules basse tension. De même l'étape 3 de programmation concerne alors la programmation de 2^{q} cellules de la mémoire en fonction des données mémorisées dans les 2^{q} bascules haute tension. De plus, les étapes 4 de chargement et 5 de programmation sont alors répétées 2^{p-q}-1 fois. L'étape 4 de chargement concerne alors le chargement, dans les 2^{q} bascules haute tension, de 2^{q} des autres données qui ont préalablement été chargées dans 2^{q} bascules basse tension à l'étape 2 de chargement. Et enfin l'étape 5 de programmation concerne alors la programmation de 2q autres cellules de la mémoire en fonction des données mémorisées dans les 2^{q} bascules haute tension.

Avec ces expressions générales, on comprend que le mode de réalisation décrit ci-dessus est un mode de réalisation particulier dans lequel p est égal à 3 et q est égal à 2.

Par ailleurs, on peut prévoir que les étapes 1) et/ou 3) à 5) sont mises en oeuvre simultanément pour plusieurs ou la totalité des mots mémoire d'une même ligne de cellules de la mémoire, lorsque la mémoire comporte une telle pluralité de mots mémoire par ligne.

Dans ce cas, il faut prévoir autant de transistors de sélection et de signaux de sélection de mot mémoire, tels que respectivement le transistor TS1 et le signal COL, qu'il y a de mots mémoire dans la ligne. Par contre les signaux de remise à zéro RLAT1 et RLAT2, les signaux de chargement LOAD1 et LOAD2, et les signaux de sélection WRMD1 et WRMD2 peuvent être fournis tels quels sur les entrées respectives des bascules de chaque registre de colonnes que comprend la mémoire. On obtient ainsi la possibilité d'une écriture en mode page conformément à l'enseignement de l'invention.

On notera qu'il ne paraît pas envisageable de mettre en oeuvre l'étape 2 de chargement simultanément pour plusieurs voire la totalité des mots mémoire d'une même ligne de cellules de la mémoire. En effet, cela nécessiterait des moyens de stockage des données inverses des données à écrire, qui soient propres à chaque mot mémoire, et cela augmenterait le nombre et la longueur des ligne de connexion nécessaire à l'acheminement de ces données sur les entrées M et N des bascules respectivement basse tension et haute tension.

## Revendications

1. Registre de colonnes convenant pour une mémoire en circuit intégré, notamment en technologie EEPROM, comprenant, pour un mot mémoire ayant 2P cellules mémoires chacune reliée à une ligne de bits respective, où p est un nombre entier non nul :
- des bascules haute tension, chacune (HV1) comprenant des moyens de mémorisation haute tension (Il-12) pour la mémorisation d'une donnée binaire sous la forme d'une haute tension de programmation (VPP) ou d'une tension nulle, couplés à des moyens (SW,WRT1,WRT2) de commutation conditionnelle et sélective, pour porter à la haute tension de programmation (VPP) une ligne de bits déterminée parmi les lignes de bits ;
- des bascules basse tension, chacune (LV0) comprenant des moyens de mémorisation basse tension (I3-I4) pour la mémorisation d'une donnée binaire sous la forme d'une basse tension d'alimentation (VCC) ou d'une tension nulle, et des moyens (N5) de couplage à l'entrée (A) d'une (HV1) des bascules haute tension, qui peuvent être activés pour charger dans ladite bascule haute tension la donnée binaire mémorisée dans la bascule basse tension,
**caractérisé en ce qu'**il y a 2^{q} bascules haute tension où q est un nombre entier strictement inférieur à p,
que la ligne de bits déterminée parmi les lignes de bits est déterminée parmi 2^{p-p} lignes de bits, et
qu'il y a 2^{P-2q} bascules basse tension.

2. Registre de colonnes selon la revendication 1, **caractérisé en ce que** les moyens (SW,WRT1,WRT2) de commutation conditionnelle et sélective des bascules haute tension comprennent un transistor MOS de type N (SW) connecté par sa grille de commande à la sortie (B) des moyens de mémorisation haute tension (I1,I2), à la haute tension de programmation (VPP) par son drain, et aux 2^{p-q} lignes de bits (BL0,BL1) par l'intermédiaire 2^{p-q} transistors MOS de type N respectifs (WRT1,WRT2), ces 2^{P-q} transistors assurant une fonction d'isolation des lignes de bits en mode lecture et une fonction de sélection d'une parmi les 2^{P-q} lignes de bits en mode écriture.

3. Registre de colonnes selon l'une des revendications précédentes, **caractérisé en ce que** les bascules haute tension (HV1,HV3,HV5,HV7) comprennent des premiers moyens de chargement (N1,N2,TC1) pour le chargement d'une donnée binaire dans les moyens de mémorisation haute tension (I1,12).

4. Registre de colonnes selon l'une des revendications précédentes, **caractérisé en ce que** les bascules basse tension (LVO,LV2,LV4,LV6) comprennent des seconds moyens de chargement (N3,N4,TC1) pour le chargement d'une donnée binaire dans les moyens de mémorisation basse tension (I3,I4).

5. Registre de colonnes selon les revendications 3 et 4, **caractérisé en ce que** les premiers et les seconds moyens de chargement partagent au moins un premier transistor de chargement (TC1), en sorte que lesdits premiers et seconds moyens de chargement peuvent être activés simultanément au moyen d'un premier signal de chargement (LOAD1) approprié qui est appliqué sur la grille de commande dudit transistor de chargement (TC1).

6. Registre de colonnes selon l'une des revendications précédentes, **caractérisé en ce que** les moyens de couplage des bascules basse tension (LV0) comprennent un transistor MOS de type N (N5) connecté par sa grille de commande à la sortie (D) des moyens de mémorisation basse tension, par son drain à l'entrée (A) des moyens de mémorisation haute tension d'une (HV1) des bascules haute tension, et par sa source à la masse à travers au moins un second transistor de chargement (TC2) et un transistor de sélection de mot (TS1) qui peuvent être rendu conducteurs respectivement par un second signal de chargement (LOAD2) et par un signal de sélection de mot (COL) appropriés.

7. Registre de colonnes selon l'une des revendications précédentes, **caractérisé en ce que** les moyens de mémorisation haute tension des bascules haute tension (HV1,HV3,HV5,HV7) comprennent deux inverseurs (I1,I2) en technologie CMOS connectés "tête-bêche" en parallèle entre la haute tension de programmation (VPP) et la masse.

8. Registre de colonnes selon l'une des revendications précédentes, **caractérisé en ce que** les moyens de mémorisation basse tension des bascules basse tension (LV0,LV2,LV4,LV6) comprennent deux inverseurs (I3,I4) en technologie CMOS connectés "tête-bêche" en parallèle entre la basse tension d'alimentation (VCC) et la masse.

9. Mémoire en circuit intégré, notamment en technologie EEPROM, comprenant un plan mémoire (MM) avec au moins un mot mémoire de 2^{p} cellules (MO-M7), chacune connectée à une ligne de bits respective (BL0,BL7), **caractérisée en ce qu'**elle comprend un registre de colonnes selon l'une des revendications précédentes.

10. Mémoire selon la revendication 9, **caractérisée en ce qu'**elle comprend plusieurs mots mémoire sur une même ligne et **en ce qu'**elle comprend des moyens pour l'écriture dans certains ou la totalité de ces mots mémoire simultanément.

11. Procédé d'écriture d'au moins un mot de données de 2^{p} bits dans une mémoire selon l'une des revendications 9 ou 10, où p est un nombre entier non nul, **caractérisé en ce qu'**il comprend les étapes suivantes :
1) effacement de toutes les cellules d'un mot mémoire ;
2) chargement de 2^{q} données dans les 2^{q} bascules haute tension (HV1, HV3, HV5, HV7), et chargement de 2^{p}-2^{q} autres données dans les 2^{p}-2^{q} bascules basse tension (LV0, LV2, LV4, LV6) ;
3) programmation de 2^{q} cellules de la mémoire en fonction des données mémorisées dans les 2^{q} bascules haute tension,
ainsi que, répétées 2^{p-q}-1 fois, les étapes suivante
4) chargement, dans les 2^{q} bascules haute tension, de 2^{q} des autres données qui ont été chargées dans 2^{q} bascules basse tension à l'étape 2) ;
5) programmation de 2^{q} autres cellules de la mémoire en fonction des données mémorisées dans les 2^{q} bascules haute tension.

12. Procédé selon la revendication 11, **caractérisé en ce que** l'étape de programmation 5 est suivie d'une étape (6) de remise à zéro des moyens de mémorisation respectifs (I3,I4 et I1,I2) des bascules basse tension (LVO,LV2,LV4,LV6) et des bascules haute tension (HV1,HV3,HV5,HV7).

13. Procédé selon l'une des revendications 11 à 12, **caractérisé en ce que** p est égal à 3 et **en ce que** q est égal à 2.

14. Procédé selon l'une des revendications 11 à 13, **caractérisé en ce que** les étapes 1) et/ou 3) à 5) sont mises en oeuvre simultanément pour plusieurs ou la totalité des mots mémoire d'une même ligne de cellules de la mémoire.

## Claims

1. Column register suitable for an integrated circuit memory, in particular using EEPROM technology, comprising, for a memory word having 2^{P} memory cells each connected to a respective bit line, where p is a non-zero whole number:
high-voltage latches, each high-voltage latch (HV1) comprising high-voltage memorisation means (I1-I2) for memorising a binary datum in the form of a high programming voltage (VPP) or a zero voltage, coupled to conditional and selective switching means (SW, WRT1, WRT2) to bring to the high programming voltage (VPP) a bit line determined from among the bit lines;
low-voltage latches, each low-voltage latch (LV0) comprising low-voltage memorisation means (I3-I4) for memorising a binary datum in the form of a low supply voltage (VCC) or a zero voltage, and coupling means (N5) at the input (A) of one (HV1) of the high-voltage latches, which can be activated to load onto said high-voltage latch the binary datum memorised in the low-voltage latch,
**characterised in that** there are 2^{q} high-voltage latches, where q is a whole number strictly less than p,
**in that** the bit line determined from among the bit lines is determined from among 2^{p-q} bit lines, and
**in that** there are 2^{p}-2^{q} low-voltage latches.

2. Column register according to claim 1, **characterised in that** the conditional and selective switching means (SW, WRT1, WRT2) of the high-voltage latches comprise an N-type MOS transistor (SW) connected by its control grid to the output (B) of the high-voltage memorisation means (I1, I2), to the high programming voltage (VPP) by its drain, and to the 2^{p-q}bit lines (BL0, BL1) via 2^{p-q} respective N-type MOS transistors (WRT1, WRT2), said 2^{p-q} transistors providing a function of isolating the bit lines in read mode and a function of selecting one of the 2^{p-q} bit lines in write mode.

3. Column register according to any one of the preceding claims, **characterised in that** the high-voltage latches (HV1, HV3, HV5, HV7) comprise first loading means (N1, N2, TC1) for loading a binary datum onto the high-voltage memorisation means (I1,I2).

4. Column register according to any one of the preceding claims, **characterised in that** the low-voltage latches (LV0, LV2, LV4, LV6) comprise second loading means (N3, N4, TC1) for loading a binary datum onto the low-voltage memorisation means (I3, I4).

5. Column register according to claims 3 and 4, **characterised in that** the first and second loading means share at least a first loading transistor (TC1), in such a way that said first and second loading means can be activated simultaneously by means of a first appropriate loading signal (LOAD1) which is applied to the control grid of said loading transistor (TC1).

6. Column register according to any one of the preceding claims, **characterised in that** the coupling means of the low-voltage latches (LV0) comprise an N-type MOS transistor (N5) connected by its control grid to the output (D) of the low-voltage memorisation means, by its drain to the input (A) of the high-voltage memorisation means of one (HV1) of the high-voltage latches, and by its source to the earth via at least a second loading transistor (TC2) and a word selection transistor (TS1), which transistors can be made conductive by an appropriate second loading signal (LOAD2) and by an appropriate word selection signal (COL) respectively.

7. Column register according to any one of the preceding claims, **characterised in that** the high-voltage memorisation means of the high-voltage latches (HV1, HV3, HV5, HV7) comprise two inverters (I1, I2), using CMOS technology, connected "head-to-tail" in parallel between the high programming voltage (VPP) and the earth.

8. Column register according to any one of the preceding claims, **characterised in that** the low-voltage memorisation means of the low-voltage latches (LV0, LV2, LV4, LV6) comprise two inverters (13, 14), using CMOS technology, connected "head-to-tail" in parallel between the low supply voltage (VCC) and the earth.

9. An integrated circuit memory, in particular using EEPROM technology, comprising a magnetic core matrix (MM) with at least one memory word of 2^{P} cells (M0-M7), each connected to a respective bit line (BL0, BL7), **characterised in that** it comprises a column register according to any one of the preceding claims.

10. Memory according to claim 9, **characterised in that** it comprises a plurality of memory words on a single line, and **in that** it further comprises means for simultaneously writing to some or all of these memory words.

11. Process for writing at least one data word of 2^{P} bits in a memory according to either claim 9 or claim 10, where p is a non-zero whole number, **characterised in that** it comprises the following steps:
1) deleting all of the cells of a memory word;
2) loading 2^{q} data onto the 2^{q} high-voltage latches (HV1, HV3, HV5, HV7) and loading 2^{p}-2^{q} other data onto the 2^{p}-2^{q} low-voltage latches (LV0, LV2, LV4, LV6);
3) programming 2^{q} cells of the memory as a function of the data memorised in the 2^{q} high-voltage latches,
as well as the following steps, repeated 2^{p-q}-1 times:
4) loading onto the 2^{q} high-voltage latches 2^{q} of the other data which were loaded onto 2^{q} low-voltage latches in step 2);
5) programming 2^{q} other cells of the memory as a function of the data memorised in the 2^{q} high-voltage latches.

12. Process according to claim 11, **characterised in that** the programming step 5 is followed by a step (b) of resetting to zero the respective memorisation means (I3, I4 and I1, I2) of the low-voltage latches (LV0, LV2, LV4, LV6) and the high-voltage latches (HV1, HV3, HV5, HV7).

13. Process according to any one of claims 11 to 12, **characterised in that** p is equal to 3 and **in that** q is equal to 2.

14. Process according to any one of claims 11 to 13, **characterised in that** steps 1) and/or 3) to 5) are implemented simultaneously for a plurality of or for all of the memory words of a single line of cells in the memory.

## Patentansprüche

1. Spaltenregister, das für einen Speicher mit integrierter Schaltung, insbesondere mit EEPROM-Technologie geeignet ist, das für ein Speicherwort mit 2^{p} Speicherzellen, die jeweils mit einer jeweiligen Bitleitung verbunden sind, wobei p eine ganze Zahl ungleich Null ist, folgendes aufweist:
- Hochspannungs-Latches, von denen jeder (HV1) Hochspannungs-Speichermittel (I1-I2) für das Speichern einer Binärinformation in Form einer hohen Programmierspannung (VPP) oder einer Nullspannung aufweist, die mit Mitteln (SW, WRT1, WRT2) zum bedingten und selektiven Umschalten gekoppelt sind, um eine aus den Bitleitungen bestimmte Bitleitung auf die hohe Programmierspannung (VPP) zu bringen,
- Niederspannungs-Latches, von denen jeder (LV0) Niederspannungs-Speichermittel (I3-I4) für das Speichern einer Binärinformation in Form einer niedrigen Versorgungsspannung (VCC) oder einer Nullspannung sowie Kopplungsmittel (N5) am Eingang (A) eines (HV1) der Hochspannungs-Latches aufweist, die aktiviert werden können, um die in dem Niederspannungs-Latch gespeicherte Binärinformation in den Hochspannungs-Latch zu laden,
**dadurch gekennzeichnet, dass** es 2^{q} Hochspannungs-Latches gibt, wobei q eine ganze Zahl ist, die streng kleiner als p ist,
dass die aus den Bitleitungen bestimmte Bitleitung aus 2^{p-q} Bitleitungen bestimmt wird, und
dass es 2^{p}-2^{q} Niederspannungs-Latches gibt.

2. Spaltenregister gemäß Anspruch 1, **dadurch gekennzeichnet, dass** die Mittel (SW, WRT1, WRT2) zum bedingten und selektiven Umschalten der Hochspannungs-Latches aufweisen: einen MOS-Transistor des Typs N (SW), der durch sein Steuergitter mit dem Ausgang (B) der Hochspannungs-Speichermittel (I1, I2), durch seinen Drain-Anschluss mit der hohen Programmierspannung (VPP), und durch jeweilige 2^{p-q} MOS-Transistoren des Typs N (WRT1, WRT2) mit den 2^{p-q} Bitleitungen verbunden ist, wobei die 2^{p-q} Transistoren eine Funktion des Isolierens der Bitleitungen im Lesemodus und eine Funktion des Auswählens aus einer der 2^{p-q} Bitleitungen im Schreibmodus sicherstellen.

3. Spaltenregister gemäß einem der vorhergehenden Ansprüche, **dadurch gekennzeichnet, dass** die Hochspannungs-Latches (HV1, HV3, HV5, HV7) erste Lademittel (N1, N2, TC1) zum Laden einer Binärinformation in die Hochspannungs-Speichermittel (I1, I2) aufweisen.

4. Spaltenregister gemäß einem der vorhergehenden Ansprüche, **dadurch gekennzeichnet, dass** die Niederspannungs-Latches (LV0, LV2, LV4, LV6) zweite Lademittel (N3, N4, TC1) zum Laden einer Binärinformation in die Niederspannungs-Speichermittel (I3, I4) aufweisen.

5. Spaltenregister gemäß den Ansprüchen 3 und 4, **dadurch gekennzeichnet, dass** die ersten und die zweiten Lademittel sich mindestens einen ersten Ladetransistor (TC1) teilen, so dass die ersten und die zweiten Lademittel gleichzeitig mittels eines ersten geeigneten Ladesignals (LOAD1) aktiviert werden können, wobei dieses auf das Steuergitter des Ladetransistors (TC1) angelegt wird.

6. Spaltenregister gemäß einem der vorhergehenden Ansprüche, **dadurch gekennzeichnet, dass** die Kopplungsmittel der Niederspannungs-Latches (LV0) einen MOS-Transistor des Typs N (N5) aufweisen, der durch sein Steuergitter mit dem Ausgang (D) der Niederspannungs-Speichermittel, durch seinen Drain-Anschluss mit dem Eingang (A) der Hochspannungs-Speichermittel eines (HV1) der Hochspannungs-Latches, und durch seinen Source-Anschluss über mindestens einen zweiten Lade-Transistor (TC2) und einen Wort-Auswähl-Transistor (TS1), die jeweils durch ein zweites geeignetes Lade-Signal (LOAD2) und ein geeignetes Wort-Auswähl-Signal (COL) zu Leitern gemacht werden können, mit der Masse verbunden ist.

7. Spaltenregister gemäß einem der vorhergehenden Ansprüche, **dadurch gekennzeichnet, dass** die Hochspannungs-Speichermittel der Hochspannungs-Latches (HV1, HV3, HV5, HV7) zwei Inverter (I1, I2) mit CMOS-Technologie aufweisen, die zwischen der hohen Programmierspannung (VPP) und der Masse parallel "Kopf-Ende"-geschaltet sind.

8. Spaltenregister gemäß einem der vorhergehenden Ansprüche, **dadurch gekennzeichnet, dass** die Niederspannungs-Speichermittel der Niederspannungs-Latches (LV0, LV2, LV4, LV6) zwei Inverter (I3, I4) mit CMOS-Technologie aufweisen, die zwischen der niedrigen Versorgungsspannung (VCC) und der Masse parallel "KopfEnde"-geschaltet sind.

9. Speicher mit integrierter Schaltung, insbesondere mit EEPROM-Technologie, aufweisend eine Speicherebene (MM) mit mindestens einem Speicherwort mit 2^{P} Zellen (M0-M7), von denen jede mit einer jeweiligen Bitleitung (BL0, BL7) verbunden ist, **dadurch gekennzeichnet, dass** er ein Spaltenregister gemäß einem der vorhergehenden Ansprüche aufweist.

10. Speicher gemäß Anspruch 9, **dadurch gekennzeichnet, dass** er mehrere Speicherworte auf einer gleichen Leitung aufweist, und dass er Mittel zum gleichzeitigen Schreiben in bestimmte oder die Gesamtheit der Speicherworte aufweist.

11. Verfahren zum Schreiben mindestens eines Datenwortes mit 2^{P} Bit in einen Speicher gemäß einem der Ansprüche 9 oder 10, wobei p eine ganze Zahl ungleich Null ist, **dadurch gekennzeichnet, dass** es die folgenden Schritte aufweist:
1) Löschen aller Zellen eines Speicherwortes,
2) Laden von 2^{q} Daten in die 2^{q} Hochspannungs-Latches (HV1, HV3, HV5, HV7) und Laden von 2^{p}-2^{q} anderen Daten in die 2^{p}-2^{q} Niederspannungs-Latches (LV0, LV2, LV4, LV6),
3) Programmieren von 2^{q} Zellen des Speichers in Abhängigkeit von den in den 2^{q} Hochspannungs-Latches gespeicherten Daten,
sowie mit 2^{p-q}-1 -maliger Wiederholung die folgenden Schritte:
4) Laden von 2^{q} der anderen Daten, die im Schritt 2) in die 2^{q} Niederspannungs-Latches geladen wurden, in die 2^{q} Hochspannungs-Latches,
5) Programmieren von 2^{q} anderen Zellen des Speichers in Abhängigkeit von den Daten, die in den 2^{q} Hochspannungs-Latches gespeichert sind.

12. Verfahren gemäß Anspruch 11, **dadurch gekennzeichnet, dass** auf den Programmierschritt 5 ein Schritt (6) des Zurücksetzens auf Null der jeweiligen Speichermittel (I3, I4 und I1, I2) der Niederspannungs-Latches (LV0, LV2, LV4, LV6) und der Hochspannungs-Latches (HV1, HV3, HV5, HV7) folgt.

13. Verfahren gemäß einem der Ansprüche 11 bis 12, **dadurch gekennzeichnet, dass** p gleich 3 und q gleich 2 ist.

14. Verfahren gemäß einem der Ansprüche 11 bis 13, **dadurch gekennzeichnet, dass** die Schritte 1) und/oder 3) bis 5) gleichzeitig für mehrere oder die Gesamtheit der Speicherworte einer gleichen Leitung von Zellen des Speichers durchgeführt werden.
